# EUROPEAN PATENT SPECIFICATION

(11) **EP 0 475 057 B1**
(45) Date of publication and mention of the grant of the patent: **02.10.1996**
(21) Application number: 91112895.7
(22) Date of filing: 31.07.1991
(51) Int. Cl.: G11C 8/00

(54) **Improvements in or relating to integrated circuits**
Integrierte Schaltkreise
Circuits intégrés

(30) Priority: 31.07.1990 US 560541
(43) Date of publication of application: 18.03.1992
(73) Proprietor: TEXAS INSTRUMENTS INCORPORATED, Dallas Texas 75265 (US)
(72) Inventor: Tabacco, Paolo, Dallas, Texas 75243 (US); Price, Carol A., Houston, Texas 77035 (US); McAdams, Hugh P., Houston, Texas 77084 (US)
(74) Representative: Leiser, Gottfried, Dipl.-Ing.

(56) References cited:
- US-A- 4 661 930
- US-A- 4 771 406
- IBM TDB vol.28, no.6, Nov. 1985, p.2742-43

## Description

This invention relates to integrated circuits, and in particular to a semiconductor memory device such as defined in the precharacterizing part of claim 1.

The development of very large scale integrated circuit (VLSI) semiconductor devices of the Dynamic Random Access Memory (DRAM) type is well known. Over the years, the industry has steadily progressed from DRAMS of the 16K type (as shown in the U.S. Pat. 4,055,444 issued to Rao) to DRAMS of the 1MB type (as shown in U.S. Pat. 4,658,377 issued to McElroy), and progressed to DRAMS of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB DRAM type, designers are faced with numerous challenges.

One cause for concern, for example, is the physical layout of the chip. The memory cells and supporting circuits must fit on a semiconductor chip of reasonable size. the size of the packaged device must be acceptable to buyers.

It is an object of this invention therefore, to provide an improved input buffer for use on a semiconductor memory device.

A prior art semiconductor memory device having an input buffer is disclosed in IBM Disclosure Bulletin, Nov. 1985, US 28, 6, p. 2742-2743.

According to the present invention the semiconductor memory device comprises the features of the characterizing part of claim 1.

Preferably, said circuit is a single stage circuit.

The circuitry for holding may include:
a row address latch coupled to a row address input buffer control signal; and
a column address coupled to a column address input buffer control signal. The single stage portion may be a CMOS single stage portion.

According to the present invention in a further aspect thereof, a device includes a memory array having memory cells arranged in rows and columns of memory cells, the memory cells having corresponding row address and column addresses;
support circuitry for reading data from the memory cells and writing data to the memory cells; and
wherein the support circuitry includes the input buffer the input buffer having one input for each multiplexed corresponding pair of row address and column address bits and having separate outputs for the row and column address bits. For example, the device may be a dynamic random access memory and the input buffer is a CMOS input buffer.

Preferably, CMOS input buffer includes:
a tri-state inverter that receives the multiplexed corresponding pair of row address bits and column address bits;
a latch to hold the previous state of the tri-state inverter when it is in the tri-state mode;
a row address latch to hold the row address bit; and
a column address latch to hold the column address bit.

According to the present invention in a yet further aspect thereof, a device includes a memory array;
periphery circuits connected to the memory array for writing data into and for reading data from the memory array and for refreshing data stored in the memory array; and
a bond pad connected with the circuit for applying the multiplexed row address and column address bits to the input buffer for separate holding.

As part of this application, an exemplary input buffer circuit is disclosed. The circuit has a single stage circuit portion for receiving a multiplexed row address bit and a multiplexed column address bit. Circuitry is connected to the single stage circuit portion for separately holding the received multiplexed row address bit and the received multiplexed column address bit. The single stage circuit portion may include a tri-state inverter having an tri-state control input coupled to an input buffer control signal and a latch to hold the output of the tri-state inverter when it is tri-stated by the input buffer control signal. The first circuit portion may be of the CMOS type. Such a circuit is useful in the memory support circuitry of an integrated circuit of the dynamic random access memory

type. The objects, advantages and features of the invention will become apparent to those of ordinary skill in the art, having reference to the following description of embodiments of

the invention which together with the accompanying drawings are provided by way only of example.

In the drawings:-
FIG. 1 is a block system level drawing illustrating a 16MB Dynamic Random Access Memory chip incorporating an embodiment of the invention,
FIG. 2 is a top view drawing illustrating the pin designations of the packaged memory chip,
FIG. 3 is a three-dimensional view of the packaged memory chip wherein the encapsulating material is rendered transparent,
FIG. 4 is an assembly view if FIG. 3,
FIG. 5 is a cross-sectional view of FIG. 3,
FIG. 6 is a top view drawing illustrating the bond pad designations of the memory chip,
FIG. 7 is a top view drawing illustrating a portion of the memory array,
FIG. 8 is a cross-sectional view of a portion of the memory array,
FIG. 9 is a side view of the cross-sectional view of FIG. 8,
FIG. 10 illustrates the PADABVF circuit and
FIG. 11 illustrates a tri-state device.

An exemplary embodiment of the invention and a memory chip including the invention will now be described.

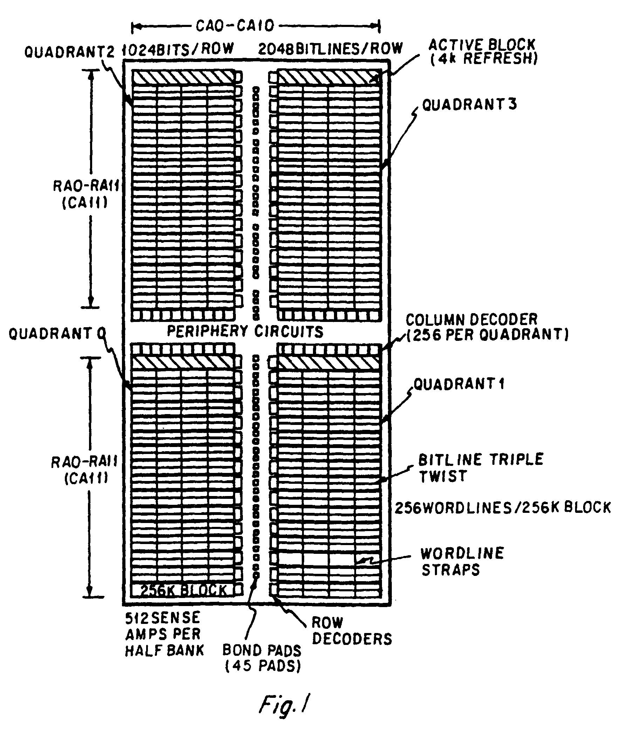

Fig. 1 illustrates a 16 Megabit Dynamic Random Access Memory Chip referred to as a 16MB DRAM. The chip size is about 325 X 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

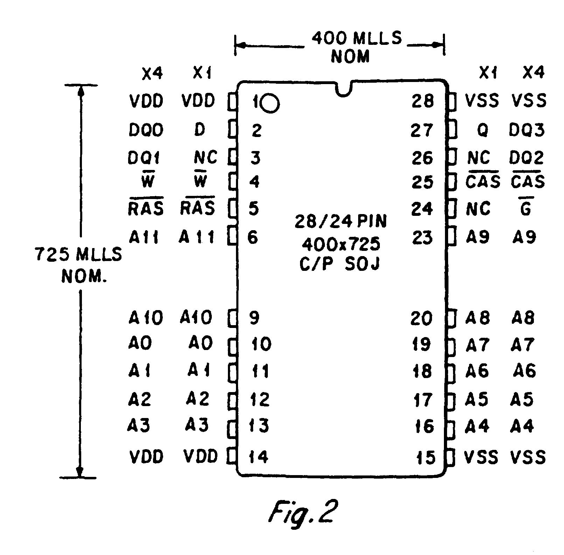

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

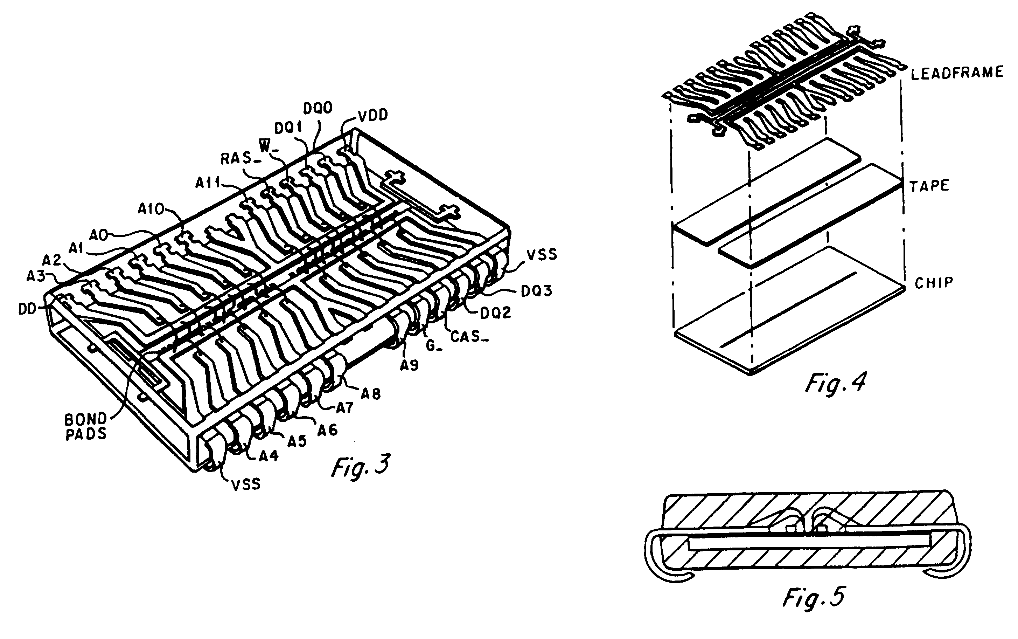

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and

FIG. 5 is a cross-section view of the packaged device.

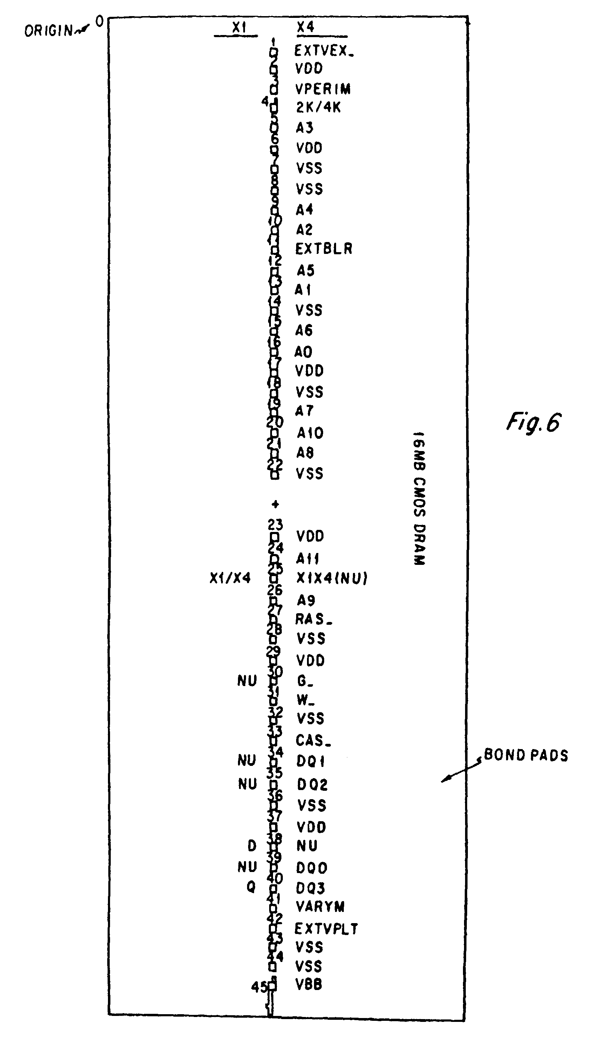

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and V_{SS} for a X1 device and omitting the bond wire for a X4 device. The resulting pin outs for the ten options may be seen in FIG. 2. The bond wire may be run between pad 25 and the V_{SS} bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to V_{SS} for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

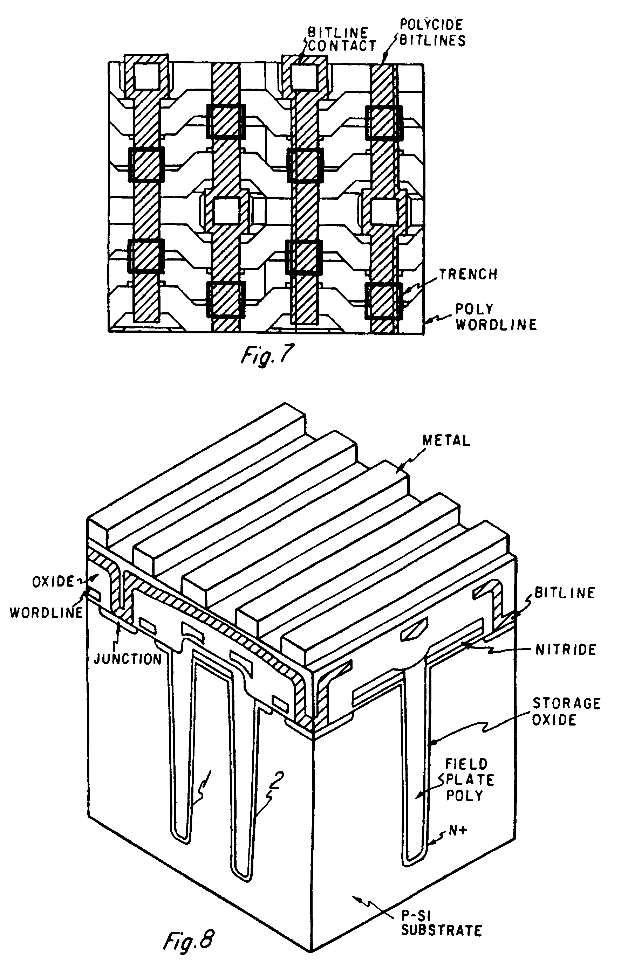

FIG. 7 is a top view of the capacitor cell layout. The bit lines are poly-3 (TiSi₂) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

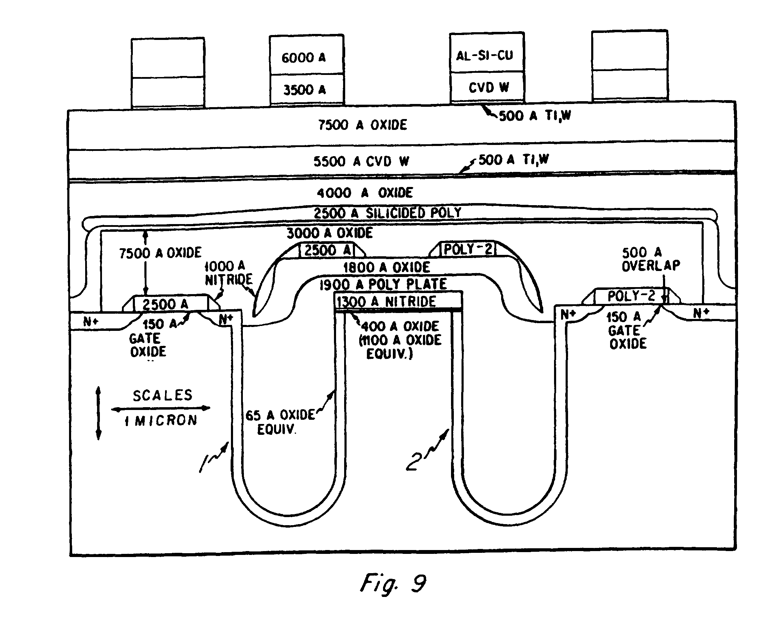

In FIG. 7, the dimensions include a 1.6um bit-line pitch by 3.0um double word line pitch, with a cell size of about 4.8um² obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell.

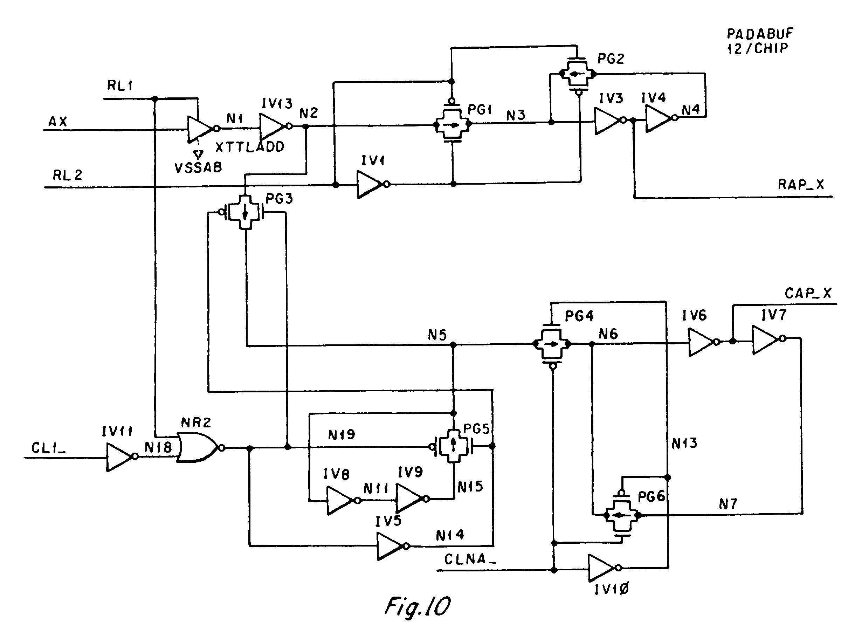

FIG. 10 illustrates the PADABUF circuit. The PADABUF circuit has five input signals and two output signals. the first input signal, RL1_, is coupled to the enable input of the inverting buffer XTTSLADD and further coupled to the first input of the NOR gate NR2. The second input, AX, is coupled to a BOND PAD and the input of the inverting buffer XTTLADD. The third input signal, RL2, is coupled to the input of the inverter IV1, and further coupled to the gate terminal of the PMOS device of the pass gate PG1 and to the gate terminal of the NMOS device of the pass gate PG2. The fourth input signal CS1_, is coupled to the second input of the NOR gate NR2 through the inverter IV11. The fifth input signal, CLNA_, is coupled to the input of the inverter IV10, to the gate terminal of the NMOS device of the passgate PG6, and to the gate terminal of the PMOS device of the pass gate PG4. The output of the inverting buffer XTTLADD, node N1, is coupled to node N2 through the inverter IV13. Node N2 is coupled to the input of the pass gate PG1 and further coupled to the input of the pass gate PG3. The output of the pass gate PG1, node N3, is coupled to the input of the inverter IV3 and further coupled to the output of the pass gate PG2. The output of the inverter IV3 is coupled to the output signal RAP_X and further coupled to the input of the inverter IV4. The output of the inverter IV4 is coupled to the input of the pass gate PG2. The output of the inverter IV1 is coupled to the gate terminal of the NMOS device of the pass gate PG1 and further coupled through the gate terminal of the PMOS device of the pass gate PG2. The output of the NOR gate NR2 is coupled to the inverter IV5, to the gate terminal of the PMOS device of the pass gate PG5, and to the gate terminal of the NMOS device of the pass gate PG3. The output of the inverter IV5 is coupled to the gate terminal of the NMOS device of the pass gate PG5 and to the gate terminal of the PMOS device of the pass gate PG3. The output of the pass gate PG3 is coupled to node N5. Node N5 is coupled to the input of the pass gate PG4 and further coupled to the output of the pass gate PG5 and to the input of the inverter IV8. The output of the inverter IV8 is coupled to the input of the inverter IV9. The output of the inverter IV9 is coupled to the input of the pass gate PG5. The output of the inverter IV10 is coupled to the gate terminal to the PMOS device of pass gate PG6 and further coupled to the gate terminal of the NMOS device of pass gate PG4. The output of pass gate PG4 is coupled to the input of the inverter IV6 and further coupled to the output of the pass gate PG6. The output of the inverter IV6 is coupled to the second output signal CAP_x and further coupled to the input of the pass gate device PG6 through the inverter IV7.

- PADABUF: - PAD ADDRESS BUFFER
- schematic FIG. 10

PADABUF multiplexes the data from the address pin and latches them as row address RAP_X and column address CAP_X accordingly.

In the first stage of the circuitry, the TTL signal for the address is converted to a CMOS level when the internal RAS signal, RL1 goes low. The delayed RAS signal, RL2 then latches in the row address. There is also a delay in the delatch of the address by RL@. This is to allow time for device to disable through precharge before address disable. The address RAP_x logic when disabled is always a '1' with RL1_ inactive high.

At the mean time, CLNA_ is asserted low to allow the address to propagate as CAP_X, thus enabling the availability of column address even before CL1_ goes low. This enables the device to operate in 'ENHANCE PAGE MODE'. As CL1_ goes low, it latches the column address at CAP_X.

Lastly, during the precharge cycle when RL1_ goes high, the XTTLADD converter, is inhibited and thus not influenced by externally changing addresses. However, the output CAP_X is maintained.

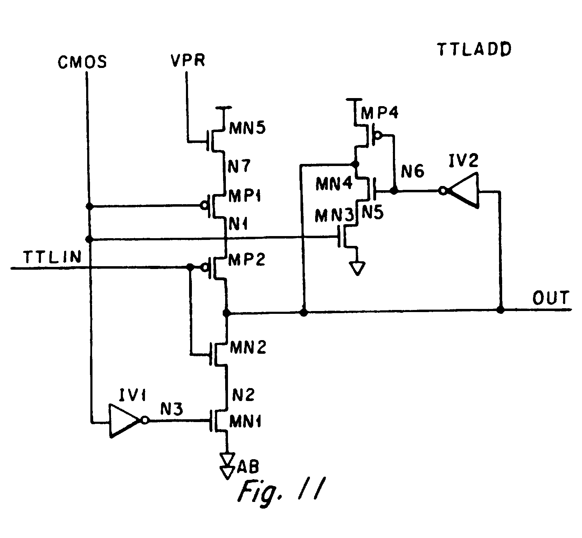

The PADABUF circuit of FIG. 10 is connected to a bond pad of the DRAM. Both row address and column address signals are input to the DRAM through the bond pad in multiplexed fashion. There are twelve such bond pads and PADABUF circuits on the DRAM, corresponding to row address input signals A0-A11 and to the column address input signals C0-C11. The PADABUF circuit of FIG. 10 includes a tri-state inverter labelled XTTLADD. This tri-state inverter is illustrated in FIG. 11 where it is labelled TTLADD. The input of tri-state inverter TTLIN is connected to the bond pad. The row and column address input signals are typically TTL level signals. The output of the tri-state inverter is CMOS level. The signal RL1_ is derived from RAS_ and controls the tri-state inverter by connecting it to the terminal labeled CMOS on FIG. 11. The pass gates PG1 and PG2 along with the inverters IV3 and IV4 form a row address latch to hold the received row address bit RAP_X. Signal RL2 controls the row address latch. the pass gates PG3 and PG5 along with the inverters IV8 and IV9 form a column address latch to hold the received column address bit CAP_x. Signal CL1_ controls the column address latch. The pass gates PG4 and PG6 along with the inverters IB6 and IV7 also form a column address latch to hold the received column address bit CAP_X. This latch is useful for the page mode of the DRAM. It is enabled by the signal CSNA_ and allows the column address to propagate even before CL1_ is active. The row address RAP_X and the column address CAP_X are CMOS level. The tri-state inverter TTLADD of FIG. 11 includes a latch comprised of transistors MP4, MN4 and MN3 and inverter IV2. This latch prevents the output of the tri-state inverter from floating when RL1 goes high. This latch and the tri-state inverter form single stage circuit.

## Claims

1. A semiconductor memory device having an input buffer (PADABUF) comprising:
a receiving circuit (XTTLADD) for receiving multiplexed row address and column address bits (AX);
a holding circuitry (PG2, IV3, IV4, PG6, IV6, IV7) connected to the circuit for separately holding the received multiplexed row address and column address bit as a held row address bit (RAP-X) and a held column address bit (CAP-X);
characterized in that said receiving circuit (XTTLADD) comprises
a tri-state inverter (TTLADD) having a tri-state control input (CMOS) coupled to an input buffer control signal (RL1_); and
a latch (IV2, MN3, MN4, MP4) to hold the output of the tri-state inverter when it is tri-stated by the input buffer control signal.

2. A semiconductor memory device, as claimed in claim 1, wherein said receiving circuit is a single stage circuit (TTLADD).

3. A semiconductor memory device, as claimed in any preceding claim, wherein the holding circuitry includes:
a row address latch (PG2, IV3, IV4) controlled by a row address input buffer control signal (RL2); and
a column address latch (PG6, IV6, IV7) controlled by a column address input buffer control signal (CLNA-).

4. The semiconductor memory device of claim 2 or claim 3, wherein the single stage circuit is a CMOS single stage circuit.

5. The semiconductor memory device, as claimed in claim 1, further comprising:
a memory array (Fig. 1) having memory cells arranged in rows and columns of memory cells, the memory cells having corresponding row addresses and column addresses;
support circuitry (Fig. 1) for reading data from the memory cells and writing data to the memory cells; and
said support circuitry including said input buffer (PADABUF), said input buffer having one input for each multiplexed corresponding pair of row address and column address bits (Ax) and having separate outputs for the held row address bit (RAP-X) and the held column address bit (CAP-X).

6. The semiconductor memory device of claim 5 wherein the memory cells are dynamic random access memory cells and the input buffer is a CMOS input buffer.

7. The semiconductor memory device of claim 6 wherein the CMOS input buffer includes:
said tri-state inverter (MN1, MN2, MP2, MP1, MN5) that receives the multiplexed corresponding pair of row address and column address bits (TTLIN);
said latch (IV2, MN3, MN4, MP4) to hold the previous state of the tri-state inverter when it is in the tri-state mode;
a row address latch (PG2, IV3, IV4) to hold the row address bit; and
a column address latch (PG6, IV6, IV7) to hold the column address bit.

8. The semiconductor memory device, as claimed in claim 1, further comprising:
a memory array (Fig. 1);
periphery circuits (Fig. 1) connected to the memory array for writing data into and for reading data from the memory array and for refreshing data stored in the memory array; and
a bond pad (AX) connected with the receiving circuit for applying the multiplexed row address and column address bits to the input buffer for separate holding.

## Patentansprüche

1. Halbleiterspeichervorrichtung mit einem Eingangspuffer (PADABUF), enthaltend:
eine Empfangsschaltung (XTTLADD) für den Empfang multiplexierter Zeilenadressen- und Spaltenadressenbits (Ax);
eine Halteschaltung (PG2, IV3, IV4, PG6, IV6, IV7), die an die Schaltung angeschlossen ist, um die empfangenen multiplexierten Zeilenadressen- und Spaltenadressenbits als ein festgehaltenes Zeilenadressenbit (RAP-X) und ein festgehaltenes Spaltenadressenbit (CAP-X) getrennt festzuhalten;
dadurch gekennzeichnet, daß die Empfangsschaltung (XTTLADD) enthält:
einen Tristate-Inverter (TTLADD) mit einem Tristate-Steuereingang (CMOS), der an ein Eingangspuffer-Steuersignal (RL1_) gekoppelt ist; und
eine Latch-Schaltung (IV2, MN3, MN4, MP4) zum Festhalten des Ausgangssignals des Tristate-Inverters, wenn er durch das Eingangspuffer-Steuersignal in den Tristate-Zustand geschaltet ist.

2. Halbleiterspeichervorrichtung nach Anspruch 1, bei welcher die Empfangsschaltung eine Einzustandsschaltung (TTLADD) ist.

3. Halbleiterspeichervorrichtung nach einem der vorhergehenden Ansprüche, bei welcher die Halteschaltung enthält:
eine Zeilenadressen-Latch-Schaltung (PG2, IV3, IV4), die durch ein Zeilenadressen-Eingangspuffersteuersignal (RL2) gesteuert ist; und
eine Spaltenadressen-Latch-Schaltung (PG6, IV6, IV7), die durch ein Spaltenadressen-Eingangspuffersteuersignal (CLNA_) gesteuert ist.

4. Halbleiterspeichervorrichtung nach Anspruch 2 oder Anspruch 3, bei welcher die Einzustandsschaltung eine CMOS-Einzustandsschaltung ist.

5. Halbleiterspeichervorrichtung nach Anspruch 1, ferner enthaltend:
eine Speichermatrix (Fig. 1) mit in Zeilen und Spalten angeordneten Speicherzellen, wobei die Speicherzellen entsprechende Zeilenadressen und Spaltenadressen haben;
eine Unterstützungsschaltungsanordnung (Fig. 1) zum Lesen von Daten aus den Speicherzellen und zum Schreiben von Daten in die Speicherzellen; und
wobei die Unterstützungsschaltungsanordnung den Eingangspuffer (PADABUF) enthält, der für jedes multiplexierte entsprechende Paar von Zeilenadressen- und Spaltenadressenbits (Ax) einen Eingang und getrennte Ausgänge für das festgehaltene Zeilenadressenbit (RAP-x) und das festgehaltene Spaltenadressenbit (CAP-x) aufweist.

6. Halbleiterspeichervorrichtung nach Anspruch 5, bei welcher die Speicherzellen dynamische Schreib/Lese-Speicherzellen sind und der Eingangspuffer ein CMOS-Eingangspuffer ist.

7. Halbleiterspeichervorrichtung nach Anspruch 6, bei welcher der CMOS-Eingangspuffer enthält:
den Tristate-Inverter (MN1, MN2, MP2, MP1, MN5), der das multiplexierte entsprechende Paar der Zeilenadressen- und Spaltenadressenbits (TTLIN) empfängt;
die Latch-Schaltung (IV2, MN3, MN4, MP4) zum Festhalten des vorherigen Zustandes des Tristate-Inverters, wenn sich dieser im Tristate-Zustand befindet;
eine Zeilenadressen-Latch-Schaltung (PG2, IV3, IV4) zum Festhalten des Zeilenadressenbits; und
eine Spaltenadressen-Latch-Schaltung (PG6, IV6, IV7) zum Festhalten des Spaltenadressenbits.

8. Halbleiterspeichervorrichtung nach Anspruch 1, ferner enthaltend:
eine Speichermatrix (Fig. 1);
Peripherieschaltungen (Fig. 1), die an die Speichermatrix angeschlossen sind, um Daten in die Speichermatrix zu schreiben und Daten aus der Speichermatrix zu lesen sowie in der Speichermatrix gespeicherte Daten aufzufrischen; und
eine Bond-Kontaktfläche (AX), die mit der Empfangsschaltung verbunden ist, um die multiplexierten Zeilenadressen- und Spaltenadressenbits an den Eingangspuffer für das getrennte Festhalten anzulegen.

## Revendications

1. Dispositif de mémoire à semiconducteur comportant un circuit tampon d'entrée (PADABUF) comprenant :
un circuit de réception (XTTLADD) pour la réception de bits d'adresse de colonne et d'adresse de ligne multiplexées (AX),
un circuit de maintien (PG2,IV3,IV4,PG6,IV6,IV7) connecté audit circuit pour maintenir séparément les bits d'adresse de colonne et d'adresse de ligne multiplexées reçus en tant que bits d'adresse actuellement maintenus (RAP-X) et bits d'adresse de colonne maintenus (CAP-X) ;
caractérisé en ce que ledit circuit de réception (XTTLADD) comporte :
un inverseur à trois états (TTLADD) comprenant une entrée de commande à trois états (CMOS) couplée à un signal de commande de circuit de tampon d'entrée (RL1_); et
un circuit de verrouillage (IV2,MN3,MN4,MP4) pour maintenir la sortie de l'inverseur à trois états lorsqu'il est commandé selon trois états par le signal de commande du circuit tampon d'entrée.

2. Dispositif de mémoire à semiconducteur selon la revendication 1, dans lequel ledit circuit de réception est un circuit à un seul étage (TTLADD).

3. Dispositif de mémoire à semiconducteur selon l'une quelconque des revendications précédentes, dans lequel le circuit de maintien comporte:
un circuit de verrouillage d'adresse de ligne (PG2,IV3,IV4) commandé par un signal de commande de circuit tampon d'entrée d'adresse de ligne (RL2) ; et
un circuit de verrouillage d'adresse de colonne (PG6,IV6,IV7) commandé par un signal de commande de circuit tampon d'entrée d'adresse de colonne (CLNA_).

4. Dispositif de mémoire à semiconducteur selon l'une des revendications 2 et 3, dans lequel le circuit à un seul étage est un circuit à un seul étage CMOS.

5. Dispositif de mémoire à semiconducteur selon la revendication 1, comportant en outre :
un réseau de mémoires (Fig. 1) comportant des cellules mémoire disposées en lignes et colonnes de cellules mémoire, les cellules mémoire ayant des adresses de ligne et des adresses de colonne correspondantes;
un circuit de support (Fig. 1) pour la lecture de données provenant des cellules mémoire et l'écriture de données dans les cellules mémoire; et
ledit circuit de support comportant ledit circuit tampon d'entrée (PADABUF), ledit circuit tampon d'entrée comportant une entrée pour chaque paire correspondante de bits d'adresse de colonne et d'adresses de ligne multiplexées (AX) et comportant des sorties séparées pour le bit d'adresse de ligne maintenus (RAP-X) et le bit d'adresse de colonne maintenu (CAP-X).

6. Dispositif de mémoire à semiconducteur selon la revendication 5, dans lequel les cellules mémoire sont des cellules de mémoires vives dynamiques et le circuit tampon d'entrée est un circuit tampon d'entrée CMOS.

7. Dispositif de mémoire à semiconducteur selon la revendication 6, dans lequel le circuit tampon d'entrée CMOS comporte :
ledit inverseur à trois états (MN1 ,MN2,MP2,MP1 ,MN5) qui reçoit la paire correspondante de bits d'adresse de colonne et d'adresse de ligne multiplexées (TTLIN) ;
ledit circuit de verrouillage (IV2,MN3,MN4,MP4) pour maintenir l'état précédent de l'inverseur à trois états lorsqu'il est dans un mode à trois états ;
un circuit de verrouillage d'adresse de ligne (PG2,IV3,IV4) pour le maintien du bit d'adresse de ligne ; et
un circuit de verrouillage d'adresse de colonne (PG6,IV6,IV7) pour le maintien du bit d'adresse de colonne.

8. Dispositif de mémoire à semiconducteur selon la revendication 1, comportant en outre :
un réseau de mémoire (Fig.1) ;
des circuits périphériques (Fig.1) connectés au réseau de mémoire pour l'écriture de données dans le réseau de mémoires et la lecture de données à partir de celui-ci, et pour le rafraîchissement des données mémorisées dans le réseau de mémoires ; et
un plot de liaison (AX) connecté au circuit de réception pour appliquer les bits d'adresse de colonne et d'adresse de ligne multiplexées au circuit tampon d'entrée pour un maintien séparé.
